# EUROPÄISCHE PATENTSCHRIFT

(11) **EP 0 880 687 B1**
(45) Veröffentlichungstag und Bekanntmachung des Hinweises auf die Patenterteilung: **03.05.2000**
(21) Anmeldenummer: 97903294.3
(22) Anmeldetag: 15.02.1997
(51) Int. Cl.: G01L 19/06, G01L 17/00

(54) **ANORDNUNG AUS EINER ELEKTRISCHEN LEITERPLATTE UND EINEM ELEKTRISCHEN DRUCKAUFNEHMER**
ARRANGEMENT COMPRISING AN ELECTRICAL PRINTED-CIRCUIT BOARD AND AN ELECTRICAL PRESSURE PICK-UP
SYSTEME COMPRENANT UNE CARTE DE CIRCUITS ET UN CAPTEUR DE PRESSION ELECTRIQUE

(30) Priorität: 16.02.1996 DE 19605795
(43) Veröffentlichungstag der Anmeldung: 02.12.1998
(73) Patentinhaber: Beru AG, 71636 Ludwigsburg (DE)
(72) Erfinder: NORMANN, Norbert, D-75223 Niefern-Öschelbronn (DE); KÜHNLE, Andreas, D-75433 Maulbronn (DE)
(74) Vertreter: Twelmeier, Ulrich, Dipl. Phys.
(86) Internationale Anmeldenummer: EP9700724
(87) Internationale Veröffentlichungsnummer: WO9730334

(56) Entgegenhaltungen:
- EP-A- 0 145 861
- EP-A- 0 288 827
- EP-A- 0 626 572
- DE-C- 4 400 439
- US-A- 4 413 524
- US-A- 4 920 805
- Patent Abstracts of Japan, Band 10, Nr 374(P-527); & JP,A,61167832 (HIROSHI KASAHARA), 1986-07-29

## Beschreibung

Die Erfindung geht aus von einer Anordnung aus einer elektrischen Leiterplatte und einem elektrischen Druckaufnehmer, welcher in einem Gehäuse einen Drucksensor hat, auf welchen der zu messende Druck mittels eines Fluids durch einen in das Gehäuse führenden Kanal übertragen wird und von welchem elektrische Leitungen ausgehen, die als Beine aus dem Gehäuse ragen und mit der Leiterplatte verbunden sind. Eine solche Anordnung ist aus der DE 44 00 439 C2 bekannt.

Unter einem Fluid wird hier ein gasförmiges Medium oder eine Flüssigkeit verstanden, wobei das gasförmige Medium, insbesondere Luft, die bevorzugte Anwendung ist. Die Verbindung des Druckaufnehmers mit der Leiterplatte geschieht üblicherweise dadurch, daß die Beine durch Bohrungen der Leiterplatte gesteckt und mit der Unterseite der Leiterplatte, teilweise auch mit der Oberseite der Leiterplatte, verlötet werden. Der Druckaufnehmer besteht im allgemeinen aus einem Drucksensor auf Halbleiterbasis, welcher in ein z.B. quaderförmiges Gehäuse eingebettet ist, welches aus einer Kunststoff-Formmasse besteht. Im Gehäuse ist ein Kanal vorgesehen, durch welchen das den zu messenden Druck übertragende Medium (zumeist Luft) den Druck auf den Drucksensor übertragen kann. Solche Druckaufnehmer sprechen infolge ihrer Kleinheit in der Regel sehr schnell auf Druckänderungen an, viel schneller, als in vielen Fällen gewünscht. Das erfordert einen erhöhten Aufwand bei der Auswertung des Drucksensorsignales, wenn man verhindern will, daß schnelle, kurzzeitige Druckschwankungen zu unnötigen Reaktionen eines Überwachungsgerätes oder gar zu einem unnötigen Alarm führen. Um dem zu begegnen, kann man das Ausgangssignal des Sensors nachträglich auf elektrischem und/oder elektronischem Wege dämpfen oder - soweit eine besondere Signalauswertung vorgesehen ist - den Algorithmus der Signalauswertung so gestalten, daß eine Tiefpaßfilterung und dadurch eine Bedämpfung des Ansprechverhaltens des Sensors erreicht wird. Das klassische Mittel dafür ist der Einsatz eines RC-Gliedes. Die nachträgliche Bedämpfung des Drucksensors stellt eine Fehlerquelle dar und erfordert einen zusätzlichen Schaltungsaufwand, welcher dem Trend zur Vereinfachung und Miniaturisierung entgegensteht. Wünschenswert wäre ein Drucksensor, der zwar klein ist, gleichwohl aber nicht so schnell anspricht, doch der Trend zur Miniaturisierung und das schneller werdende Ansprechverhalten gehen Hand in Hand.

Der vorliegenden Erfindung liegt die **Aufgabe** zugrunde, einen Weg aufzuzeigen, wie man ohne großen Aufwand zu kleinen, elektronischen Druckaufnehmem kommen kann, deren Ausgangssignal nicht nachträglich elektronisch bedämpft werden muß. Konkreter Ausgangspunkt für diese Aufgabenstellung ist die Suche nach einem geeigneten Druckaufnehmer für die Überwachung des Luftdrucks in Reifen an Fahrzeugen. Dafür wird ein Druckaufnehmer benötigt, der einerseits so klein ist, daß er zusammen mit einer Batterie und einer aktiven elektronischen Schaltung im oder am Ventilfuß untergebracht werden kann, andererseits aber so träge ist, daß er nicht auf die unvermeidlichen schnellen Druckänderungen während der Fahrt anspricht, sondern nur auf die infolge von Undichtigkeiten und Reifenschäden auftretenden langsameren Druckänderungen, welche von den schnelleren Druckänderungen überlagert werden. Druckschwankungen, deren Druckänderungsgeschwindigkeit größer als 500 mbar/s sind, sind in diesem Zusammenhang uninteressant und erschweren die Auswertung des Ausgangssignals des Drucksensors nur.

Zur **Lösung** der gestellten Aufgabe wird erfindungsgemäß eine Anordnung mit den im Anspruch 1 angegebenen Merkmalen vorgeschlagen. Vorteilhafte Weiterbildungen der Erfindung sind Gegenstand der Unteransprüche. Im Anspruch 17 ist eine Anwendung umgegeben.

Die Erfindung hat den Vorteil, daß sie die Verwendung von sehr kleinen, schnell ansprechenden, elektronischen Druckaufnehmem ermöglicht, gleichwohl aber keine nachträgliche Bedämpfung von deren Ausgangssignal erfordert. Erreicht wird das dadurch, daß der Druckaufnehmer mit einfachsten Mitteln mechanisch bedämpft wird, indem der Kanal, durch welchen der zu messende Druck zum Drucksensor geführt wird, an der Außenseite des Gehäuses in geeigneter Weise abgeschirmt wird, so daß sich bei einer Druckerhöhung der Strömungswiderstand für das in den Kanal eintretende Fluid und bei einem Druckabfall der Strömungswiderstand für das aus dem Kanal austretende Fluid erhöht und auf diese Weise schnelle Druckschwankungen unterdrückt werden, bevor sie den Drucksensor erreichen.

Um zu diesem Ergebnis zu gelangen, bedarf es erfindungsgemäß überhaupt keiner aufwendigen Maßnahmen. Es genügt, auf das Gehäuse des Druckaufnehmers eine den Kanal überdeckende dünne Platte zu kleben, die den Zutritt des druckübertragenden Fluids (insbesondere von Luft) hinreichend erschwert. Der Zutritt kann dadurch ermöglicht sein, daß die Platte perforiert ist oder daß die Platte in einem definierten, geringen Abstand von der Oberfläche des Gehäuses angeordnet ist (z.B. dadurch, daß die Platte an ihrer Unterseite flache Vorsprünge hat) oder dadurch, daß in der Platte und/oder in der Oberfläche des Gehäuses ces Druckaufnehmers durch das jeweils gegenüberliegende Teil abgedeckte Kanäle vorgesehen sind, die vom Rand der Platte bis in den Bereich des Kanals führen und deren Länge und Querscnnitt den Strömungswiderstand bestimmen. Ein hoher Strömungswiderstand kann z.B. nicht nur dadurch erreicht werden, daß die Strömungsquerschnitte zusammengenommen gering sind, sondern auch dadurch, daß die Strömungswege lang sind, was durch Vergrößern der Platte und/oder Führen der Kanäle über Umwege (mäanderförmig oder spiralig) erreicht werden kann. Ein besonderer Vorteil besteht darin, daß auf diese Weise ein und derselbe Druckaufnehmer je nach Anwendungsfall unterschiedlich stark bedämpft werden kann, indem man die Ausführungsform der Platte und der von ihr und der Oberfläche des Druckaufnehmergehäuses begrenzten Strömungswege entsprechend unterschiedlich wählt.

Besonders bevorzugt ist eine Weiterbildung der Erfindung, bei welcher der Druckaufnehmer in SMD-Technik mit der Leiterplatte verbunden wird. Bei der SMD-Technik werden die Beine des Druckaufnehmers nicht durch Bohrungen der Leiterplatte hindurchgesteckt und verlötet, sondern die Beine werden J-, L- oder Z-förmig abgewinkelt, auf die Oberfläche der Leiterplatte gestellt und mit ihr verlötet (SMD = **S**urface **M**ounted **D**evice). Die SMD-Technik ermöglicht auf rationelle Weise eine hohe Packungsdichte auf der Leiterplatte, was für die Miniaturisierung von Baugruppen wichtig und für den hier bevorzugten Einsatzzweck in der Reifendrucküberwachung günstig ist. Die Erfindung ist in Kombination mit der SMD-Technik besonders dann vorteilhaft, wenn man den Druckaufnehmer nicht wie üblich so anordnet, daß sein Kanal der Leiterplatte abgewandt, sondern der Leiterplatte zugewandt ist. Zu diesem Zweck müssen die Beine des Druckaufnehmers in die entgegengesetzte Richtung wie sonst üblich gebogen werden, nämlich zu der Gehäuseseite hin, auf welcher sich der Druckkanal befindet. Das Trimmen und Formen der Beine kann in an sich bekannter Weise in einem Stanz-Biegewerkzeug erfolgen und führt zu einer reproduzierbaren Form und Lage der Beinchen. Das kann man sich in Weiterbildung der Erfindung zunutze machen, indem man das Stanz-Biegewerkzeug so ausbildet, daß die Beinchen mit ihren abgewinkelten Füßen, die zur Auflage auf der Leiterplatte bestimmt sind, geringfügig um ein definiertes Maß über die Oberfläche des Druckaufnehmergehäuses vorstehen, so daß sich automatisch beim Verlöten des Druckaufnehmers mit der Leiterplatte zwischen dieser und dem Druckaufnehmergehäuse ein enger Spalt ergibt, der den gewünschten Strömungswiderstand bietet. Auf diese Weise erfordert das Bilden des gewünschten Strömungswiderstandes weder ein zusätzliches Bauteil noch einen zusätzlichen Fertigungsschritt! Es ist aber auch möglich, das Gehäuse des Druckaufnehmers mit abgedichtetem Spalt oder spaltfrei auf der Leiterplatte zu montieren und in der Leiterplatte eine oder mehrere den Strömungswiderstand bildende Bohrungen vorzusehen, die in den Kanal des Druckaufnehmers münden. Eine derartige Anordnung ist in SMD-Technik möglich, weil in SMD-Technik die Leiterplatte mit ihrer Rückseite nicht über ein Lötschwallbad geführt wird.

Die dämpfende Wirkung des Strömungswiderstandes kann dadurch verstärkt werden, daß der Strömungswiderstand mit einer verglichen mit dem Rauminhalt des Kanals vergrößerten Druckkapazität kombiniert wird. Als Druckkapazität dient der von dem Fluid zwischen dem Strömungswiderstand und dem elektronischen Drucksensor eingenommene Raum, welcher das Volumen des Druckkanals im Druckaufnehmergehäuse einschließt. Der Strömungswiderstand und die Druckkapazität zeigen in Kombination ein Tiefpaß-Verhalten ähnlich einem elektrischen RC-Glied und können deshalb als ein fluidischer Tiefpaß oder Drucktiefpaß aufgefaßt werden. Durch Vergrößerung der Druckkapazität (Kammervolumen zwischen dem Strömungswiderstand und dem Drucksensor) wird die Zeitkonstante, die das Ansprechverhalten des Druckaufnehmers bestimmt, vergrößert, so daß sich eine stärkere Bedämpfung ergibt. Eine solche Vergrößerung läßt sich auf unterschiedliche Weise erreichen, beispielsweise dadurch, daß der Kanal im Druckaufnehmergehäuse durch eine Haube abgeschirmt wird, deren Volumen zum Volumen des Kanals hinzutritt. Eine solche Haube könnte - wenn es um kleine Volumina geht - durch eine ausgehöhlte Platte gebildet sein, könnte aber auch durch ein gewölbtes Formteil, z.B. durch ein geprägtes Blech, verwirklicht sein. Die Druckkapazität kann ferner dadurch vergrößert werden, daß man den im Druckaufnehmer vorgesehenen Kanal insbesondere stufenförmig erweitert . Die Erweiterung kann sich nahezu über die gesamte Oberseite des Gehäuses des Druckaufnehmers erstrecken.

Eine weitere vorteilhafte Möglichkeit, die Zeitkonstante des Druckaufnehmers zu vergrößern, besteht darin, in dem die Druckkapazität darstellenden Hohlraum ein Filtermaterial vorzusehen, insbesondere ein feinporiges Staubfilter, welches den Strömungswiderstand erhöht und den zusätzlichen Vorteil hat, das Eindringen von Staub und anderen störenden Partikeln in den Kanal zu verhindern oder mindestens zu erschweren. Ein Filtermaterial kann auch auf die Außenseite der Abschirmung geklebt werden, wenn diese perforiert ist, um den Zutritt des Fluids zum Kanal zu ermöglichen. Sind die Bohrung(en), die in der Abschirmung vorgesehen sind, hinreichend eng, dann hat das einerseits den Vorteil, daß sie den Kanal im Druckaufnehmergehäuse nicht nur gegenüber schnellen Druckschwankungen, sondern auch gegen Verunreinigungen abschirmen. Die Perforationen oder Bohrungen in der Abschirmung werden durch ein auf die Außenseite der Abschirmung aufgeklebtes Staubfilter davor bewahrt, sich zuzusetzen.

Das Ausbilden eines Strömungswiderstandes hat nicht nur den Vorteil, den Druckaufnehmer zu bedämpfen, sondern hat auch Fertigungsvorteile. In SMD-Technik hergestellte Baugruppen werden üblicherweise mittels einer Vergußmasse auf Kunstharzbasis vergossen oder mit einem Schutzlack beschichtet. Dieses wird durch die Abschirmung und durch die neue Art und Weise der Anordnung des Druckaufnehmers erleichtert, denn sie sind geeignet, das Eindringen der Vergußmasse in den Kanal des Druckaufnehmergehäuses zu verhindern, wenn die Strömungsquerschnitte, die den vorgesehenen Strömungswiderstand bilden, und die Viskosität der Vergußmasse so aufeinander abgestimmt sind, daß die Vergußmasse nicht unter die Abschirmung fließen kann.

Zur weiteren Erläuterung der Erfindung sind Zeichnungen beigefügt.
- Figur 1: zeigt einen erfindungsgemäßen Druckaufnehmer in der Draufsicht auf die Seite, die seinem Druckkanal abgewandt ist,
- Figur 2: zeigt den Schnitt A-A durch den Druckaufnehmer gemäß Figur 1,
- Figur 3: zeigt eine andere Ausführungsform des Druckaufnehmers in der Draufsicht auf die Seite mit dem Druckkanal,
- Figur 4: zeigt den Schnitt A-A durch den Druckaufnehmer gemäß Figur 3,
- Figur 5: zeigt eine dritte Ausführungsform eines Druckaufnehmers in der Draufsicht auf seine Seite mit dem Druckkanal,
- Figur 6: zeigt den Schnitt A-A durch den Druckaufnehmer gemäß Fig. 5, die
- Figuren 7 bis 10: zeigen unterschiedliche Arten der Montage des Druckaufnehmers aus Figur 2 in SMD-Technik auf einer Leiterplatte, die
- Figuren 11 bis 14: zeigen unterschiedliche Arten der Montage des Druckaufnehmers aus Figur 4 in SMD-Technik auf einer Leiterplatte,
- Figur 15: zeigt eine Abwandlung der Figur 11, nämlich mit einem Druckaufnehmer gemäß den Figuren 5 und 6, die
- Figuren 16 bis 19: zeigen die in Figur 11 als Abschirmung dienende Platte in einer Ansicht ihrer dem Druckaufnehmer zugewandten Seite mit unterschiedlichen Arten der Strukturierung der Oberfläche, und die
- Figuren 20 und 21: zeigen die Möglichkeit eines Vergießens des Druckaufnehmers bei den in den Figuren 11 bis 15 dargestellten Montagearten.

Gleiche und einander entsprechende Teile sind in den unterschiedlichen Ausführungsbeispielen mit übereinstimmenden Bezugszahlen bezeichnet.

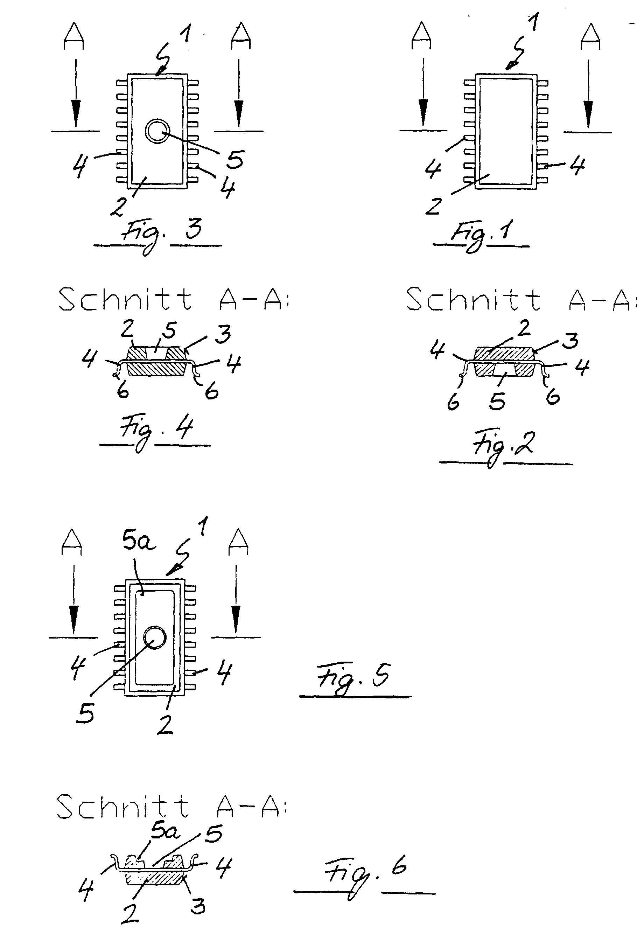

Der in den Figuren 1 und 2 dargestellte Druckaufnehmer 1 hat ein ungefähr quaderförmiges, im Grundriß rechteckiges Gehäuse 2 mit abgeschrägten Flanken 3. Das Gehäuse 2 besteht aus einer isolierenden Formmasse. Aus dem Gehäuse ragen Beine 4 heraus, welche aus einem Leadframe ausgeschnitten und annähernd Z-förmig gebogen sind. Die Beine 4 sind die Zuleitungen eines von der Formmasse umhüllten und im einzelnen nicht dargestellten elektronischen Drucksensors. An der Unterseite des Gehäuses 2 ist mittig ein sich von außen nach innen konisch verengender Kanal 5 vorgesehen, welcher den Zugang eines Fluids zum Drucksensor ermöglicht, welches den zu messenden Druck überträgt. Als Fluid kommt überwiegend Luft in Frage, aber auch andere Gase oder Flüssigkeiten, die sich mit dem Sensor vertragen, z.B. ein Öl. Die Füße 6 der Beine 4 stehen geringfügig über die Unterseite des Gehäuses 2 vor.

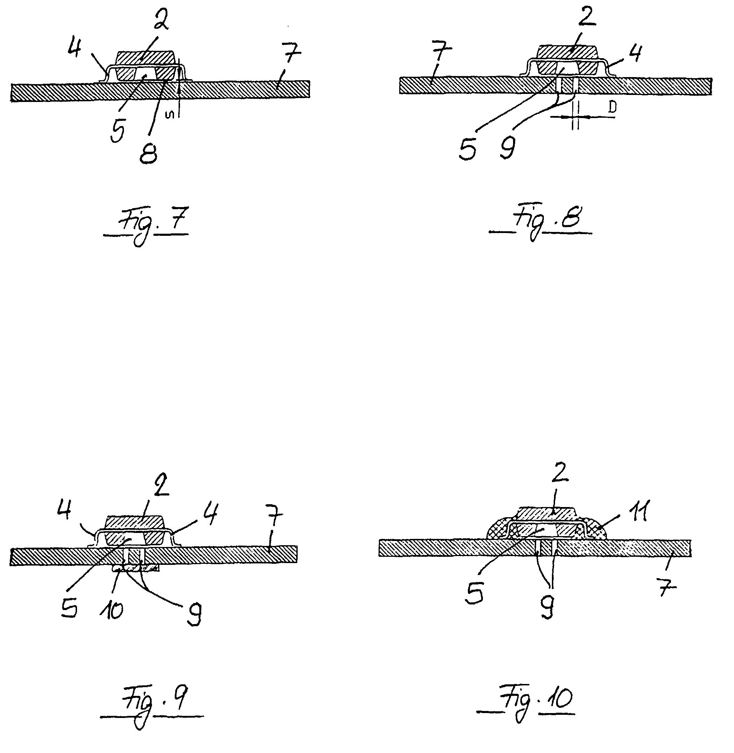

Der in den Figuren 3 und 4 dargestellte Druckaufnehmer unterscheidet sich von dem in den Figuren 1 und 2 dargestellten Druckaufnehmer darin, daß sich der Kanal 5 nicht an der Unterseite, sondern an der Oberseite des Gehäuses befindet.

Der in den Figuren 5 und 6 dargestellte Druckaufnehmer unterscheidet sich von dem in den Figuren 1 und 2 dargestellten Druckaufnehmer darin, daß der Kanal 5 eine stufenförmig abgesetzte konische Erweiterung 5a hat, welche sich nahezu über die gesamte Unterseite des Gehäuses 2 erstreckt und durch die der Rauminhalt des Kanals 5 wesentlich vergrößert worden ist.

Montiert man den in Figur 2 dargestellten Druckaufnehmer in SMD-Technik auf einer Leiterplatte 7, dann ergibt sich das in Figur 7 dargestellte Bild: Die Leiterplatte 7 schirmt den Kanal 5 ab. Zwischen der Unterseite des Gehäuses 2 und der Leiterplatte 7 besteht ein enger Spalt 8 mit der Höhe s, die in Figur 7 übertrieben groß dargestellt ist und dem Fluid (vorzugsweise ist es Luft) den Zutritt zum Kanal 5 über einen Strömungswiderstand ermöglicht. Der Strömungswiderstand stellt in Verbindung mit dem Rauminhalt des Kanals 5 einen fluidischen Tiefpaß dar, welcher verhindert, daß schnelle Druckschwankungen den Drucksensor erreichen. Der durch den Spalt 8 gebildete Strömungsquerschnitt kann dadurch variiert werden, daß seine Höhe s variiert wird, z.B. dadurch, daß die Füße 6 der Beine 4 mehr oder weniger über die Unterseite des Gehäuses 2 vorstehen. Einfacher, weil dafür keine Änderung des die Beine 7 formenden Stanz-Biegewerkzeuges erforderlich ist, ist es, den Spalt 8 zu strukturieren, insbesondere dadurch, daß bei der Leiterplattenherstellung am Ort des Spaltes 8 Kupferbahnen gebildet werden oder Lötmetall aufgedruckt wird oder ein Lötstopplack aufgedruckt wird oder eine sonstige Druckpaste aufgetragen wird oder dadurch, daß die Leiterplatte stellenweise ausgefräst wird. Durch eine Ausfräsung der Leiterplatte an der dem Kanal 5 gegenüberliegenden Stelle kann darüber hinaus der Rauminhalt der fluidischen Kapazität (Druckkapazität), die in die Zeitkonstante des Drucksensors eingeht, vergrößert werden. Einer Vergrößerung dieser Zeitkonstante dient auch die stufenförmige Erweiterung 5a des Kanals 5 gemäß den Figuren 5 und 6.

Der Spalt 8 kann dazu herangezogen werden, zu verhindern, daß mit dem Fluid störende Partikel unter das Gehäuse 2 und in den Kanal 5 gelangen. Kennt man den Durchmesser der kleinsten störenden Partikel, dann kann man die Höhe s zwischen dem Gehäuse 2 des Druckaufnehmers und der Leiterplatte 7 kleiner wählen als die kleinsten störenden Partikel.

Die Höhe s des Spaltes 8 kann minimal sein oder sogar zu Null reduziert sein, wenn durch die Leiterplatte 7 hindurch ein Zugang zum Kanal 5 geschaffen wird. Im Ausführungsbeispiel gemäß Figur 8 ist dies durch Bohrungen 9 geschehen. Den Durchmesser D dieser Bohrungen 9 kann man ebenfalls so wählen, daß die kleinsten auftretenden störenden Partikel die Leiterplatte 7 nicht durchqueren können. Sollten die Bohrungen dann so eng werden, daß der Strömungswiderstand zu groß wird, oder sollten die störenden Partikel so fein sein, daß die Bohrungen 9 sie nicht zurückhalten können, kann man ergänzend ein Filter 10 vorsehen, welches im Ausführungsbeispiel gemäß Figur 9 auf die Unterseite der Leiterplatte 7 geklebt ist und die Bohrungen 9 überdeckt. Dieses Filter, bei dem es sich z.B. um eine textile Filtermatte handeln kann, kann nicht nur als Feinfilter (Staubfilter) dienen, sondern ist auch geeignet, den Strömungswiderstand zu beeinflussen. Eine Beeinflussung des Strömungswiderstandes ist insbesondere dann möglich, wenn ein Filter in den Kanal 5 und/oder dessen Erweiterung eingesetzt wird.

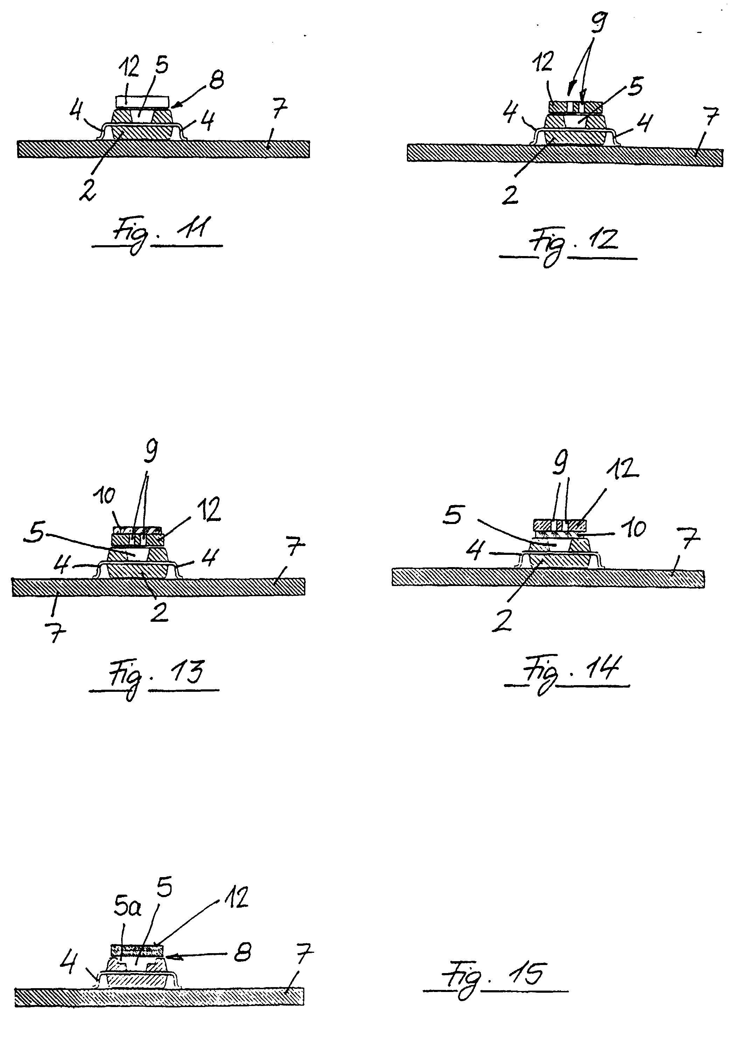

Will man den Druckaufnehmer zusammen mit weiteren Bestandteilen einer auf der Leiterplatte 7 vorgesehenen, hier nicht dargestellten elektronischen Schaltung vergießen, dann muß man im Ausführungsbeispiel gemäß Figur 7 dafür sorgen, daß in der Vergußmasse ein Kanal offen bleibt, welcher durch die Vergußmasse 8 hindurch zum Spalt 8 führt. In den Ausführungsbeispielen gemäß den Figuren 8 bis 10 ist das einfacher, weil der Zugang zum Kanal 5 durch die Leiterplatte 7 hindurch erfolgt. In diesem Fall muß man lediglich sicherstellen, daß die Vergußmasse beim Vergießen nicht in den Spalt 8 und weiter in den Kanal 5 eindringt. Das kann einmal dadurch erreicht werden, daß man den Spalt 8 hinreichend schmal ausbildet und die Höhe s des Spaltes so auf die Viskosität der Vergußmasse abstimmt, daß diese nicht unter das Gehäuse fließen kann. Man kann aber auch hergehen und den Spalt 8 vor dem eigentlichen Vergießen abdichten, wie in Figur 10 dargestellt. Zu diesem Zweck kann z.B. ein herkömmlicher SMD-Kleber an der Unterseite des Gehäuses 2 aufgetragen werden, bevor der Druckaufnehmer 1 auf der Leiterplatte 7 montiert und verlötet wird. Der Spalt 8 kann aber auch noch nach dem Verlöten des Druckaufnehmers 1 mit der Leiterplatte 7 z.B. durch Auftragen eines Klebers verschlossen werden.

Die in den Figuren 8 bis 10 dargestellten Ausführungsbeispiele eignen sich besonders für den Einsatz in der Reifendrucküberwachung.

Der in den Figuren 5 und 6 dargestellte Druckaufnehmer kann ebenfalls auf die in den Figuren 7 bis 10 dargestellten Weisen montiert werden.

Die Figuren 11 bis 14 zeigen, wie sich der in den Figuren 3 und 4 dargestellte Druckaufnehmer erfindungsgemäß montieren läßt. Die Ausführungsbeispiele in den Figuren 11 bis 14 unterscheiden sich von denen in den Figuren 7 bis 10 darin, daß der Kanal 5 nicht zur Leiterplatte 7, sondern nach oben weist; die Aufgabe seiner Abschirmung übernimmt in diesem Fall eine gesonderte Platte 12, wobei der Zutritt zum Kanal 5 in analoger Weise zu den in den Figuren 7 bis 10 dargestellten Ausführungsformen verwirklicht ist, nämlich in Figur 11 durch einen engen Spalt 8 zwischen der Platte 12 und der Oberseite des Gehäuses 2, und in den Figuren 12 bis 14 durch Bohrungen 9 in der Platte 12, ggf.. in Kombination mit einem Filter 10, welches auf der Platte 12 (siehe Figur 13) oder zwischen der Platte 12 und dem Gehäuse 2 angeordnet sein kann (siehe Figur 14).

Auch in den Beispielen gemäß den Figuren 11 bis 14 kann der Kanal 5 eine stufenförmige Erweiterung 5a haben (siehe Figur 15), welche die Zeitkonstante des Druckaufnehmers 1 vergrößert und es gleichzeitig ermöglicht, eine größere Anzahl von Bohrungen 9 in der Platte 12 und/oder längere Strömungswege vorzusehen.

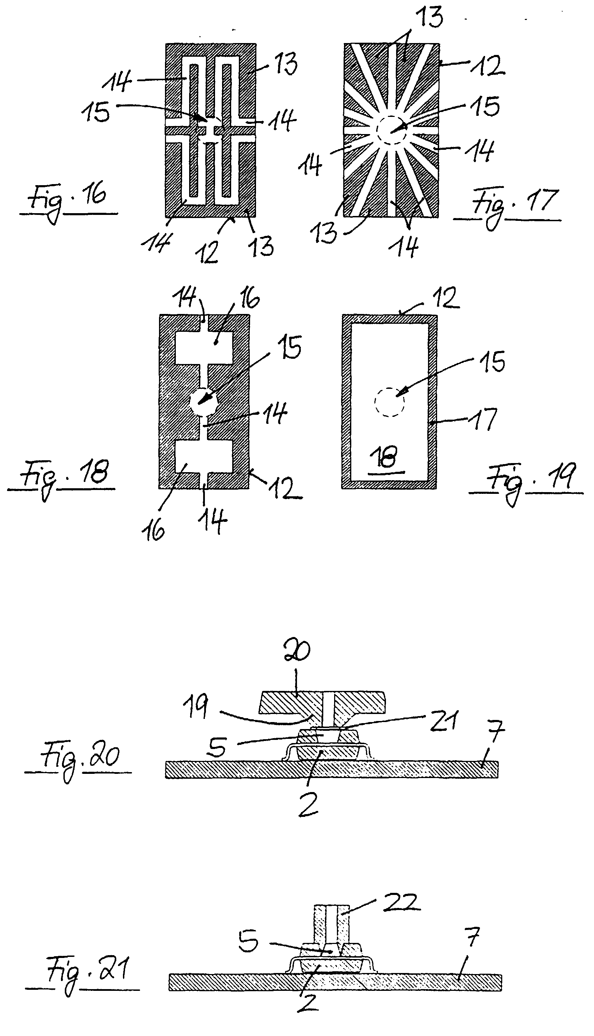

Figur 16 zeigt die Unterseite der Platte 12 aus Figur 11. Die Unterseite ist dadurch strukturiert worden, daß sie selektiv mit einer Druckpaste 13 bedruckt wurde, um mäanderförmig verlaufende Kanäle 14 zu bilden, welche von wenigen Stellen am Rand der Platte 12 ausgehen (im gezeichneten Beispiel sind es vier Stellen) und auf Umwegen im Zentrum der Platte 12 zusammentreffen, an einer gestrichelt angedeuteten Stelle 15, die dem Kanal 5 gegenüberliegt. Durch Ändern der Gestalt und der Dimensionierung der Kanäle läßt sich deren Strömungswiderstand verändern. Die in Figur 17 dargestellte Art der Strukturierung der Unterseite der Platte 12 mit einer Anzahl von sternförmig verlaufenden Kanälen 14 hat einen geringeren Strömungswiderstand als das Beispiel in Figur 16 zur Folge. Bei der in Figur 18 dargestellten Art der Strukturierung der Unterseite der Platte 12 sind nur zwei Kanäle 14 ausgebildet, die jeweils durch eine größere Kammer 16 hindurchführen und dadurch zu einer wesentlichen Dämpfung des Ansprechverhaltens des Druckaufnehmers führen. Im Ausführungsbeispiel gemäß Figur 19 schließt eine rahmenförmige Umrandung 17 auf der Unterseite der Platte 12 eine Kammer 18 ein, welche zusammen mit dem Rauminhalt des Kanals 5, der in diese Kammer 18 mündet, und zusammen mit dem Strömungswiderstand des Spalts 8 zwischen der Platte 12 und dem Gehäuse 2 einen das Ansprechverhalten des Druckaufnehmers dämpfenden fluidischen Tiefpaß bildet. Eine entsprechende Strukturierung ist auch auf der Oberseite der Leiterplatte 7 im Falle der Montageart gemäß den Figuren 7 bis 19 möglich. Die Strukturierung kann nicht nur mit Hilfe einer Druckpaste erfolgen, sondern - insbesondere auf der Leiterplatte 7 - auch durch selektives Metallisieren (wie beim Bilden von Leiterbahnstrukturen an sich bekannt), durch selektives Auftragen eines Lötmetalls oder eines Lötstopplackes oder durch die Verwendung von Fräs- oder Kunststoff-Formteilen mit Kanälen.

Ein Vergießen des Druckaufnehmers gemäß Figur 4 ist dadurch möglich, daß die Öffnung des Druckkanales 5 durch ein geeignetes Element 19, das Bestandteil eines den Druckaufnehmer 1 und eine ihm ggf.. zugeordnete Elektronik umgebenden Gehäuses 20 ist, abgedichtet wird (siehe Figur 20), wobei dieses Element 19 zusätzlich durch einen Dichtring 21 oder durch das Filter 10 abgedichtet sein kann. Eine andere Möglichkeit besteht darin, eine Hülse 22 in den Kanal 5 einzusetzen (siehe Figur 21). Die Hülse 22 muß so lang sein, daß sie bis über die spätere Oberkante des Vergusses ragt.

## Patentansprüche

1. Anordnung aus einer elektrischen Leiterplatte (7) und einem elektrischen Druckaufnehmer (1), welcher in einem Gehäuse (2) einen Drucksensor hat, auf welchen der zu messende Druck mittels eines Fluics durch einen in das Gehäuse (2) führenden Kanal (5) übertragbar ist und von welchem elektrische Leitungen ausgehen, die als Beine (4) aus dem Gehäuse (2) ragen und mit der Leiterplatte (7) verbunden sind, **dadurch gekennzeichnet,** daß der Kanal (5) an der Außenseite des Gehäuses (2) abgeschirmt ist. so daß sich für das in den Kanal (5) eintretende und für das den Kanal (5) verlassende Fluid der Strömungswiderstand erhöht.

2. Anordnung nach Anspruch 1, **dadurch gekennzeichnet,** daß cer Kanal (5) durch eine Platte (7,12) abgeschirmt ist.

3. Anordnung nach Anspruch 2, **dadurch gekennzeichnet,** daß die Platte (7) die Leiterplatte ist.

4. Anordnung nach einem der vorstehenden Ansprüche, **dadurch gekennzeichnet**, daß die Beine (4) des Druckaufnehmers (1) in SMD-Technik mit der Leiterplatte (7) verbunden sind.

5. Anordnung nach Anspruch 1, **dadurch gekennzeichnet,** daß der Kanal (5) durch eine Haube abgeschirmt ist.

6. Anordnung nach Anspruch 5, **dadurch gekennzeichnet,** daß die Haube durch Aushöhlen einer Platte (7,12) gebildet ist.

7. Anordnung nach Anspruch 1, **dadurch gekennzeichnet,** daß sich der Kanal (5) von innen nach außen erweitert.

8. Anordnung nach Anspruch 7, **dadurch gekennzeichnet,** daß die Erweiterung (5a) des Kanals (5) stufenförmig erfolgt ist.

9. Anordnung nach einem der vorstehenden Ansprüche, **dadurch gekennzeichnet**, daß unter der Abschirmung (7,12) ein Filter vorgesehen ist.

10. Anordnung nach einem der vorstehenden Ansprüche, **dadurch gekennzeichnet,** daß die Abschirmung (7,12) perforiert ist

11. Anordnung nach Anspruch 10, **dadurch gekennzeichnet,** daß die Abschirmung (7,12) durch ein Filter (10) abgedeckt ist.

12. Anordnung nach einem der vorstehenden Ansprüche, **dadurch gekennzeichnet**, daß zwischen dem Gehäuse (2) und der Abschirmung (7,12) durch Rippen unterteilte Kanäle verlaufen.

13. Anordnung nach Anspruch 12, **dadurch gekennzeichnet,** daß die Kanäle in der Oberfläche des Gehäuses (2) und/oder der Abschirmung (7,2) vorgesehen sind.

14. Anordnung nach Anspruch 1, 2 oder 3, **dadurch gekennzeichnet,** daß der Spalt (8) zwischen dem Gehäuse (2) und der Abschirmung (7,12) strukturiert ist.

15. Anordnung nach Anspruch 14, **dadurch gekennzeichnet,** daß der Scalt (8) durch Vorsehen von Kupferbahnen (13, 17), einfaches oder wiederholtes Aufdrucken von Lötmetall, von Lötstopplack, von Druckpaste oder durch Ausfräsungen in der Abschirmung (7,12) und/oder in dem angrenzenden Gehäuse (2) oder durch Zwischenfügen eines mit einem oder mehreren Kanälen versehenen Frästeil ocer Formteil strukturiert ist.

16. Anordnung nach einem der Ansprüche 3, 4, 7 - 10, **dadurch gekennzeichnet,** daß der Spalt zwischen der Leiterplatte (7) und dem Gehäuse (2) gänzlich verschlossen ist und zur Druckbeaufschlagung des Druckaufnehmers (1) in der Leiterplatte (7) eine oder mehrere Löcher (9) vorgesehen sind, welche Verbindung mit dem Kanal (5) haben.

17. Vorrichtung für die Überwachung des Luftdrucks in Reifen auf Fahrzeugrädem mit einer am ocer im Ventilfuß des Rades vorzusehenden Anordnung nach einem der vorstehenden Ansprüche.

## Claims

1. An arrangement made comprising an electrical circuit board (7) and an electrical pressure transducer (1) which has, in a housing (2), a pressure sensor onto which the pressure to be measured can be transferred by means of a fluid through a channel (5) leading into the housing (2), and from which there proceed electrical leads which project out of the housing (2) as legs (4) and are connected to the circuit board (7), characterized in that the channel (5) is shielded on the outer side of the housing (2) so that the flow resistance for the fluid entering and leaving the channel (5) increases.

2. The arrangement as defined in Claim 1, characterized in that the channel (5) is shielded by a plate (7, 12).

3. The arrangement as defined in Claim 2, characterized in that the plate (7) is the circuit board.

4. The arrangement as defined in any of the foregoing claims, characterized in that the legs (4) of the pressure transducer (1) are joined to the circuit board (7) using SMD technology.

5. The arrangement as defined in Claim 1, characterized in that the channel (5) is shielded by a cap.

6. The arrangement as defined in Claim 5, characterized in that the cap is fort med by hollowing out a plate (7, 12).

7. The arrangement as defined in Claim 1, characterized in that the channel (5) widens from the inside out.

8. The arrangement as defined in Claim 7, characterized in that the widening (5a) of the channel (5) is accomplished in steps.

9. The arrangement as defined in any of the foregoing claims, characterized in that a filter is provided under the shielding (7, 12).

10. The arrangement as defined in any of the foregoing claims, characterized in that the shielding (7, 12) is perforated.

11. The arrangement as defined in Claim 10, characterized in that the shielding (7, 12) is covered by a filter (10).

12. The arrangement as defined in any of the foregoing claims, characterized in that channels subdivided by fins run between the housing (2) and the shielding (7, 12).

13. The arrangement as defined in Claim 12, characterized in that the channels are provided in the surface of the housing (2) andlor of the shielding (7, 12).

14. The arrangement as defined in Claim 1, 2, or 3, characterized in that the gap (8) between the housing (2) and the shielding (7, 12) is patterned.

15. The arrangement as defined in Claim 14, characterized in that the gap (8) is patterned by the provision of copper traces (13, 17), by single or repeated printing of solder metal, of solder resist, of printing paste, or by milled-out recesses in the shielding (7, 12) and/or in the adjacent housing (2), or by interposing a milled or shaped element equipped with one or more channels.

16. The arrangement as defined in any of Claims 3, 4, 7 through 10, characterized in that the gap between the circuit board (7) and the housing (2) is entirely sealed, and to allow pressure to act upon the pressure transducer (1), one or more holes (9) which communicate with the channel (5) are provided in the circuit board (7).

17. An apparatus for monitoring the air pressure in tires on vehicle wheels, having an arrangement as defined in any of the foregoing claims to be provided on or in the valve base of the wheel.

## Revendications

1. Agencement constitué par une carte de circuits imprimés électrique (7) et par un capteur de pression électrique (1) qui possède un palpeur de pression dans un boîtier (2) auquel la pression à mesurer peut être transmise à l'aide d'un fluide à travers un canal (5) menant au boîtier (2) et à partir duquel partent des circuits électriques qui font saillie sous la forme de branches (4) par rapport au boîtier (2) et qui sont reliés à la carte de circuits imprimés (7), caractérisé en ce que le canal (5) est déparasité par écran sur le côté externe du boîtier (2), si bien que la résistance hydraulique pour le fluide pénétrant dans le canal (5) et pour le fluide quittant le canal (5) augmente.

2. Agencement selon la revendication 1, caractérisé en ce que le canal (5) est déparasité par écran à l'aide d'une plaque (7, 12).

3. Agencement selon la revendication 2, caractérisé en ce que la plaque (7) représente la carte de circuits imprimés.

4. Agencement selon l'une quelconque des revendications précédentes, caractérisé en ce que les branches (4) du capteur de pression (1) sont reliées à la carte de circuits imprimés (7) à l'aide d'une technologie des particules montées en surface (technologie SMD).

5. Agencement selon la revendication 1, caractérisé en ce que le canal (5) est déparasité par écran à l'aide d'un capot.

6. Agencement selon la revendication 5, caractérisé en ce que le capot est formé par des évidements pratiqués dans une plaque (7, 12).

7. Agencement selon la revendication 1, caractérisé en ce que le canal (5) s'élargit depuis l'intérieur vers l'extérieur.

8. Agencement selon la revendication 7, caractérisé en ce que l'élargissement (5a) du canal (5) a lieu par paliers.

9. Agencement selon l'une quelconque des revendications précédentes, caractérisé en ce qu'on prévoit un filtre en dessous de l'écran antiparasite (7, 12).

10. Agencement selon l'une quelconque des revendications précédentes, caractérisé en ce que l'écran antiparasite (7, 12) est perforé.

11. Agencement selon la revendication 10, caractérisé en ce que l'écran antiparasite (7, 12) est recouvert d'un filtre (10).

12. Agencement selon l'une quelconque des revendications précédentes, caractérisé en ce que des canaux subdivisés par des nervures s'étendent entre le boîtier (2) et l'écran antiparasite (7, 12).

13. Agencement selon la revendication 12, caractérisé en ce que les canaux sont prévus dans la surface du boîtier (2) et/ou de l'écran antiparasite (7, 12).

14. Agencement selon la revendication 1, 2 ou 3, caractérisé en ce que la fente entre le boîtier (2) et l'écran antiparasite (7, 12) est structurée.

15. Agencement selon la revendication 14, caractérisé en ce que la fente (8) est structurée en prévoyant des bandes de cuivre (13, 17), en imprimant une ou plusieurs fois un métal d'apport de brasage, une réserve de soudure par brasage, une pâte d'impression ou en pratiquant des fraisures dans l'écran antiparasite (7, 12) et/ou dans le boîtier limitrophe (2) ou encore en intercalant un élément obtenu par fraisage ou un élément obtenu par moulage muni d'un ou de plusieurs canaux.

16. Agencement selon les revendications 3, 4, 7 - 10, caractérisé en ce que la fente entre la carte de circuits imprimés (7) et le boîtier (2) est complètement fermée et un ou plusieurs trous (9) sont prévus pour la sollicitation de pression du capteur de pression (1) dans la carte de circuits imprimés (7), qui établissent une liaison avec le canal (5).

17. Dispositif pour la surveillance de la pression atmosphérique dans des pneumatiques sur des roues de véhicules automobiles, comprenant un agencement selon l'une quelconque des revendications précédentes qui doit être prévu sur ou dans l'embase de valve de la roue.
